(19) Europäisches Patentamt / European Patent Office / Office européen des brevets

(11) **EP 4 187 265 A1**

(12) **DEMANDE DE BREVET EUROPEEN**

(43) Date de publication:
**31.05.2023 Bulletin 2023/22**

(21) Numéro de dépôt: **22208996.3**

(22) Date de dépôt: **23.11.2022**

(51) Classification Internationale des Brevets (IPC):
**G01R 31/28** (2006.01)     **G01R 31/26** (2020.01)
**G01R 31/265** (2006.01)     **G01Q 60/24** (2010.01)
**G01Q 60/30** (2010.01)

(52) Classification Coopérative des Brevets (CPC):
**G01R 31/2648; G01Q 60/30; G01R 31/2656;**
G01R 31/2831

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(30) Priorité: **30.11.2021 FR 2112723**

(71) Demandeur: **Commissariat à l'énergie atomique et aux énergies alternatives**
**75015 Paris (FR)**

(72) Inventeurs:
• **AUBRIET, Valentin**
**38054 GRENOBLE CEDEX 09 (FR)**
• **BOROWIK, Lukasz**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(54) **DISPOSITIF ET PROCÉDÉ DE CARACTÉRISATION D'UN MATÉRIAU SEMICONDUCTEUR**

(57) La présente description concerne un système (200) de caractérisation d'un semiconducteur par mesure de photo-tension de surface comprenant :
- une sonde de Kelvin (210) comprenant à une première extrémité une plaque conductrice adaptée à être en regard d'une surface d'un échantillon (10) de semiconducteur ;
- un circuit électrique (202) relié à une autre extrémité de la sonde et adapté à relier la sonde à l'échantillon ;
- un générateur (230) de signal d'excitation (P) adapté à exciter le semiconducteur ;
- un générateur de vibration (240) adapté à appliquer à la plaque un mouvement d'oscillation orthogonalement à la surface de l'échantillon ;
- une unité de commande (224) du générateur de vibration adaptée à générer un signal de commande ($O_{SCV}$) de vibration ;
- un générateur (230) de signal de modulation (S) adapté à moduler le signal de commande et former un signal de commande modulé ($V_{MOD}$) destiné au générateur de vibration ;
le signal de modulation étant déphasé par rapport au signal d'excitation ; et
- un moyen de détermination d'une valeur ($V_{KP}$) de tension de polarisation entre la sonde et l'échantillon, ladite valeur étant déterminée sur la base d'un courant ($I_{KP}$) généré dans le circuit électrique par l'oscillation de la plaque, et permettant de déterminer une valeur de photo-tension de surface.

FIG. 2B

## Description

<u>Domaine technique</u>

La présente description concerne de façon générale la caractérisation des défauts dans un matériau semiconducteur, et en particulier, la caractérisation par photo-tension de surface.

<u>Technique antérieure</u>

La présence de défauts dans un matériau semiconducteur d'un composant peut provoquer une diminution des performances du composant, par exemple des performances électriques. Cela peut concerner par exemple une cellule solaire, un photodétecteur, un transistor, une diode électroluminescente (light-emitting diode, LED). Il est donc généralement recherché la détection et/ou la caractérisation de ces défauts.

La détection et/ou caractérisation des défauts dans un matériau semiconducteur peut s'effectuer suivant différentes techniques. On s'intéresse dans la présente description à la technique dite de mesure de photo-tension de surface, également connue sous le terme "surface photovoltage" en anglais (SPV). La méthode SPV consiste à déterminer la variation du potentiel de surface d'un matériau semiconducteur dans une configuration sous illumination par rapport à une configuration dans l'obscurité, et inversement. Cette variation de potentiel de surface, que l'on peut désigner par "paramètre SPV", dépend notamment des défauts de surface du matériau semiconducteur. Ainsi, la détermination du paramètre SPV peut renseigner sur les défauts du matériau semiconducteur mesuré.

Il est en particulier recherché la détermination de la dynamique de variation du paramètre SPV, ou dynamique de photo-tension de surface, que l'on peut désigner par "dynamique de SPV" ou "dynamique SPV", notamment la dynamique de photo-tension de surface entre la configuration sous illumination et la configuration dans l'obscurité, et inversement, pour mieux détecter et caractériser des défauts dans un matériau semiconducteur.

<u>Résumé de l'invention</u>

Il existe un besoin d'une technique de caractérisation adapté à déterminer une dynamique de photo-tension de surface.

Un mode de réalisation pallie tout ou partie des inconvénients des techniques de caractérisation par mesure de photo-tension de surface connues.

Un mode de réalisation prévoit un système de caractérisation d'un semiconducteur par mesure de photo-tension de surface, le système comprenant :

- une sonde de Kelvin comprenant à une première extrémité une plaque électriquement conductrice adaptée à être disposée en regard d'une première surface d'un échantillon de semiconducteur ;
- un circuit électrique relié à une autre extrémité de la sonde et adapté à relier électriquement ladite sonde à l'échantillon ;
- un générateur de signal d'excitation adapté à exciter le semiconducteur ;
- un générateur de vibration adapté à appliquer à la plaque un mouvement d'oscillation selon une direction sensiblement orthogonale à la première surface de l'échantillon ;
- une unité de commande du générateur de vibration adaptée à générer un signal de commande de vibration ;
- un générateur de signal de modulation adapté à moduler le signal de commande de vibration de manière à former un signal de commande modulé destiné à être envoyé au générateur de vibration ;
- le signal de modulation étant déphasé, d'une valeur de déphasage, par rapport au signal d'excitation ; et
- un moyen de détermination d'une valeur de tension de polarisation entre la sonde de Kelvin et l'échantillon, ladite valeur étant déterminée sur la base d'un courant généré dans le circuit électrique par l'oscillation de la plaque, et ladite valeur permettant de déterminer une valeur de photo-tension de surface du semiconducteur, pour la valeur de déphasage.

Selon un mode de réalisation, le système comprend un générateur de tension adapté à générer la tension de polarisation entre la sonde de Kelvin et l'échantillon.

Selon un mode de réalisation, le moyen de détermination comprend une boucle de rétroaction avec en entrée le courant, et en sortie la valeur de tension de polarisation qui permet de réduire le courant, par exemple d'annuler ledit courant.

Selon un mode de réalisation, le système comprend un multiplicateur de tension configuré pour multiplier le signal de commande de vibration par le signal de modulation.

Selon un mode de réalisation, le système comprend un moyen de réglage du déphasage du signal de modulation par rapport au signal d'excitation, configuré pour appliquer plusieurs valeurs de déphasage entre ledit signal de modulation et ledit signal d'excitation ;

le moyen de détermination étant adapté à déterminer, pour chaque valeur de déphasage, une valeur de tension de polarisation sur la base du courant généré dans le circuit électrique par l'oscillation de la plaque, chaque valeur de tension de polarisation déterminée permettant de déterminer une valeur de photo-tension de surface du semiconducteur.

Selon un mode de réalisation, le moyen de réglage du déphasage du signal de modulation par rapport au signal d'excitation comprend un retardateur.

Selon un mode de réalisation, la plaque s'étend selon un plan principal destiné à être disposé en regard de la première surface de l'échantillon, les dimensions de la plaque dans ledit plan principal étant supérieures ou égales à 15 micromètres.

Un mode de réalisation prévoit un procédé de caractérisation d'un semiconducteur par mesure de photo-tension de surface, le procédé mettant en œuvre un système de caractérisation selon un mode de réalisation, et comprenant :

- disposer la plaque électriquement conductrice en regard d'une première surface d'un échantillon de semiconducteur, et relier l'autre extrémité de la sonde à l'échantillon par le circuit électrique ;
- générer un signal d'excitation à l'aide du générateur de signal d'excitation, de manière à exciter le matériau semiconducteur ;
- générer un signal de commande de vibration à l'aide de l'unité de commande ;
- générer un signal de modulation à l'aide du générateur de signal de modulation, et moduler le signal de commande de vibration par le signal de modulation de manière à générer un signal de commande modulé ; le signal de modulation étant déphasé d'une valeur de déphasage par rapport au signal d'excitation ;
- générer, à l'aide du générateur de vibration commandé par le signal de commande modulé, un mouvement d'oscillation de la plaque selon une direction sensiblement orthogonale à la première surface de l'échantillon ;
- déterminer une valeur de tension de polarisation entre la sonde de Kelvin et l'échantillon sur la base d'un courant généré dans le circuit électrique par l'oscillation de la plaque ; et
- déterminer une valeur de photo-tension de surface sur la base de la valeur déterminée de tension de polarisation, pour la valeur de déphasage.

Selon un mode de réalisation, le procédé comprend en outre :

- générer la tension de polarisation entre la sonde de Kelvin et l'échantillon, pour la détermination de la valeur de tension de polarisation.

Selon un mode de réalisation, la valeur de tension de polarisation est déterminée à l'aide d'une boucle de rétroaction avec en entrée le courant, ladite valeur de tension de polarisation étant sélectionnée pour réduire le courant, par exemple annuler ledit courant.

Selon un mode de réalisation, le procédé comprend :

- régler plusieurs valeurs de déphasage du signal de modulation par rapport au signal d'excitation ;
- déterminer, pour chaque valeur de déphasage, une valeur de tension de polarisation sur la base du courant généré dans le circuit électrique par l'oscillation de la plaque ; et
- déterminer une valeur de photo-tension de surface sur la base de chaque valeur déterminée de tension de polarisation ; le nombre de valeurs de déphasages étant par exemple adapté à déterminer une dynamique de photo-tension de surface dans le temps.

Selon un mode de réalisation, le procédé comprend en outre :

- déposer préalablement sur la première surface de l'échantillon du semiconducteur des charges négatives ou positives ; la valeur de photo-tension de surface étant déterminée en fonction du dépôt de charges réalisé.

Selon un mode de réalisation, la tension de polarisation est une tension continue.

Selon un mode de réalisation, le signal de commande de vibration est une tension alternative.

Selon un mode de réalisation, le signal de modulation comprend des impulsions, par exemple des impulsions de tension.

Selon un mode de réalisation, le signal d'excitation est un signal Laser, un signal électrique ou un signal magnétique, par exemple sous forme d'impulsions.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A représente schématiquement un exemple de système de caractérisation d'un matériau semiconducteur par une technique dite "KPFM" ;

la figure 1B représente schématiquement un exemple de système de caractérisation d'un matériau semiconducteur par une technique dite "pp-KPFM" ;

la figure 2A représente schématiquement un système de caractérisation d'un matériau semiconducteur selon un mode de réalisation ;

la figure 2B représente schématiquement sous forme de blocs le système de caractérisation de la figure 2A ;

la figure 3A illustre un procédé de caractérisation d'un matériau semiconducteur selon un mode de réalisation ; et

la figure 3B illustre un procédé de caractérisation d'un matériau semiconducteur selon un autre mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, tous les composants des systèmes et blocs décrits ne sont pas détaillés. Par exemple, les composants de la boucle de rétroaction, de l'unité de commande, des générateurs de signaux ou du générateur de vibration ne sont pas détaillés, étant à la portée de la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un système de caractérisation d'un échantillon de semiconducteur lorsque ledit échantillon s'étend selon une direction horizontale, étant entendu que l'échantillon peut être orienté selon une autre direction, par exemple une direction verticale ou une direction oblique.

Sauf précision contraire, les expressions "environ", "approximativement", "sensiblement", et "de l'ordre de" signifient à 10 % près, de préférence à 5 % près.

Pour caractériser des défauts dans un matériau semiconducteur, une technique connue est la technique de mesure de photo-tension de surface (SPV) décrite plus avant. Le paramètre SPV peut être mesuré par la technique dite "KPFM" pour "Kelvin Probe Force Microscopy" en anglais, ou microscopie à sonde de Kelvin.

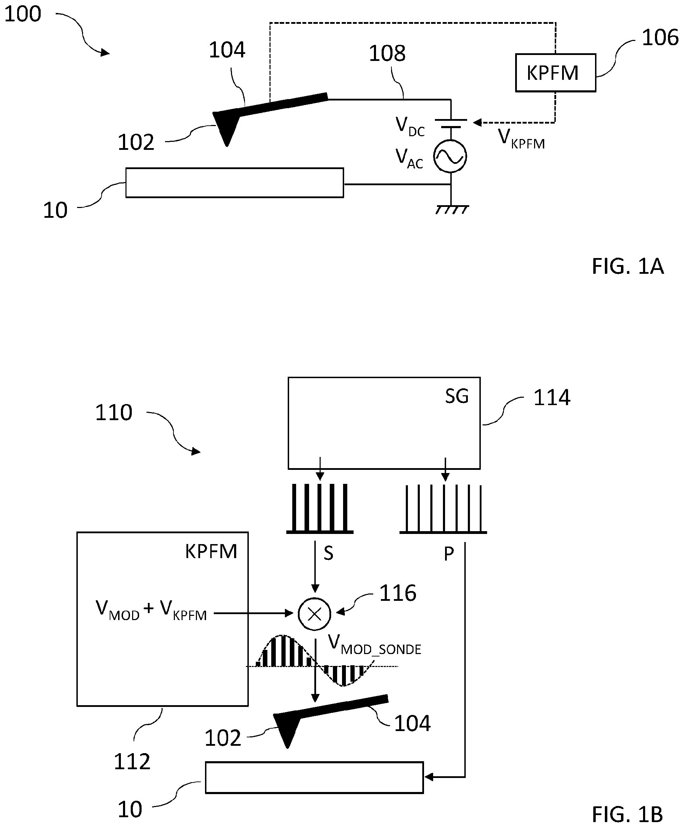

La figure 1A représente schématiquement un exemple de système de caractérisation 100 d'un matériau semiconducteur par une technique KPFM. Dans le système représenté, une pointe conductrice 102 est montée sur une poutre (cantilever) 104. La pointe est disposée au droit d'un échantillon 10 de semiconducteur, et la poutre est reliée électriquement à l'échantillon de semiconducteur par un circuit électrique 108. L'extrémité libre de la pointe peut présenter une taille nanométrique, de quelques nanomètres à quelques dizaines de nanomètres. Le système pointe/échantillon forme une capacité.

Deux polarisations sont appliquées entre la pointe et la surface de l'échantillon au niveau du circuit électrique 108 : une polarisation continue $V_{DC}$ et une polarisation sinusoïdale $V_{AC}$. La polarisation sinusoïdale $V_{AC}$ induit une différence de potentiel électrostatique $\Delta V$ entre la pointe et la surface de l'échantillon donnée par :

$$\Delta V = CPD + V_{DC} + V_{AC}$$

où CPD désigne la différence de potentiel de contact (Contact Potential Difference). La différence de potentiel de contact peut être définie, dans cette configuration, comme étant la différence de potentiel électrostatique entre la surface de l'échantillon et la pointe à l'équilibre.

La différence de potentiel électrostatique $\Delta V$ couplée à la capacité du système pointe/échantillon induit une force électrostatique qui cause un déplacement sous forme d'oscillation à la pointe (et/ou de modulation du décalage de la fréquence d'oscillation) selon une direction perpendiculaire à la surface de l'échantillon 10. L'amplitude d'oscillation de la pointe (ou le décalage en fréquence) est notamment lié(e) à la valeur de différence de potentiel de contact (CPD) qui existe entre la pointe et l'échantillon, et à la différence ($V_{DC}$ - CPD) lorsqu'une polarisation continue $V_{DC}$ est appliquée. Ainsi, la valeur d'amplitude de l'oscillation (ou le décalage en fréquence) peut être utilisé(e) pour réaliser la mesure de CPD. Plus précisément, il est possible de déterminer la valeur de CPD en déterminant une valeur de la polarisation continue $V_{DC}$ permettant d'annuler l'amplitude de l'oscillation (ou la modulation du décalage en fréquence). Cette valeur de polarisation, qui peut être désignée "tension de compensation" (du CPD), est généralement déterminée par une boucle de rétroaction, avec en entrée l'amplitude d'oscillation (ou le décalage en fréquence). La boucle de rétroaction peut être par exemple en modulation d'amplitude ou en modulation de fréquence. La tension de compensation générée par la boucle de rétroaction peut être désignée $V_{KPFM}$. La tension sinusoïdale permettant d'induire une force électrostatique entre la pointe et l'échantillon peut être désignée $V_{MOD}$. La boucle de rétroaction peut être intégrée dans une unité KPFM 106 adaptée à déterminer la valeur de tension de compensation $V_{KPFM}$, et ainsi le CPD.

La boucle de rétroaction (ou l'unité KPFM 106) peut comprendre un amplificateur à détection synchrone (en anglais Lock-In Amplifier, LIA), et/ou une boucle à verrouillage de phase (en anglais Phase-Locked Loop, PLL), en mode modulation d'amplitude et/ou de fréquence respectivement. Le LIA permet de détecter l'amplitude d'oscillation du levier induit par la tension sinusoïdale dans le mode modulation d'amplitude. La PLL permet de détecter le décalage en fréquence dans le mode modulation de fréquence.

La mesure de photo-tension de surface par la technique KPFM peut être réalisée en déterminant et en comparant des valeurs de CPD obtenues à l'obscurité et sous illumination, toutes autres conditions similaires.

Un inconvénient d'un tel système est que l'électronique de mesure KPFM, notamment la mise en œuvre d'une boucle de rétroaction, rend la mesure relativement lente, par exemple de quelques centaines de millisecondes. Ce délai de mesure ne permet généralement pas de mesurer des dynamiques de SPV, celles-ci étant généralement trop rapides par rapport aux constantes de temps de l'électronique de mesure KPFM.

La figure 1B représente sous forme de blocs un exemple de système de caractérisation 110 d'un matériau semiconducteur par une technique dite pompe-sonde-KPFM (en anglais pump-probe-KPFM, pp-KPMF), combinant une technique pompe-sonde avec une technique KPFM . Le principe d'un système pompe-sonde est d'exciter un semiconducteur (pompe), puis de mesurer une réponse à cette excitation suivant une fenêtre temporelle (sonde). Une résolution temporelle de la mesure peut être obtenue par réglage du décalage temporel entre l'excitation et la mesure, c'est-à-dire entre la pompe et la sonde. Un système de caractérisation basé sur la technique pp-KPFM peut permettre de déterminer une dynamique de SPV.

Le système 110 représenté comprend deux blocs principaux :

- un bloc microscopie à sonde de Kelvin (bloc KPFM) 112 comprenant les éléments permettant d'effectuer une mesure KPFM, similaires aux éléments décrits en lien avec le système 100 de la figure 1A ; une tension de modulation sinusoïdale est générée en sortie de ce bloc, correspondant à la somme ($V_{MOD}$ + $V_{KPFM}$) en reprenant les termes donnés en relation avec la figure 1A ;
- un bloc de génération de signal (bloc SG) 114 adapté à générer des signaux de tension : un premier signal de tension S pour la sonde, et un deuxième signal de tension P pour la pompe, les deux signaux étant représentés sous forme d'impulsions (pulses), par exemple en créneaux.

La multiplication, en utilisant par exemple un multiplicateur de tension 116, du premier signal de tension S du bloc SG 114 par la tension de modulation sinusoïdale ($V_{MOD}$ + $V_{KPFM}$) du bloc KPFM 112 donne une tension de modulation de sonde $V_{MOD\_SONDE}$ qui correspond à une tension constituée d'impulsions avec la même enveloppe sinusoïdale que la tension de modulation sinusoïdale ($V_{MOD}$ + $V_{KPFM}$) . La tension de modulation de sonde envoyée à la pointe est celle qui est utilisée dans la boucle de rétroaction du KPFM. Ainsi, la boucle de rétroaction du KPFM ne compense que la différence de potentiel de contact (CPD) entre la pointe et l'échantillon qui existe pendant chaque impulsion.

Le deuxième signal de tension P du bloc SG 114 permet l'excitation de l'échantillon 10, par exemple l'illumination de l'échantillon. Le signal de tension P de la pompe et le signal de tension S de la sonde (et ainsi la tension de modulation de sonde) sont synchronisés, par exemple via le générateur de signal dans le bloc SG 114, et différents déphasages entre les impulsions de la sonde et de la pompe sont appliqués. L'évolution temporelle de la CPD est surveillée en enregistrant la tension ($V_{KPFM}$) à la sortie de la boucle de rétroaction du KPFM en fonction des déphasages entre les impulsions de la sonde et celles de la pompe.

La technique pompe-sonde combinée avec la technique KPFM permet ainsi de déterminer la différence de potentiel de surface (CPD) en fonction du déphasage entre la pompe et la sonde, et ce, selon différents déphasages de la sonde par rapport à la pompe. Dit autrement, cela permet de mesurer la CPD à différents instants après (les déphasages sont alors des retards), voire avant (les déphasages sont alors des avances de phase), l'excitation du semiconducteur par la pompe. Cela permet de générer des mesures de photo-tension de surface (SPV) résolues dans le temps, c'est à dire une dynamique SPV. La dynamique SPV peut par exemple être représentée sous forme de spectre ou de courbe.

Plusieurs inconvénients découlent toutefois de cette technique pp-KPFM.

La résolution temporelle du SPV est limitée par le rapport signal sur bruit qui tend à augmenter avec la présence d'une couche d'isolant (par exemple, couche d'oxyde ou couche de passivation) sur la couche de semiconducteur (par exemple, couche de silicium) dont on recherche la présence de défaut(s), un défaut pouvant être entre la couche de semiconducteur et la couche d'isolant. La détermination d'une dynamique de SPV par la technique pp-KPFM peut être difficile, voire impossible, lorsque la couche d'isolant est supérieure à une épaisseur donnée, par exemple supérieure à environ 50 nm.

En outre, avec la technique pp-KPFM, il n'est pas possible de modifier le régime électrique en surface de l'échantillon de semiconducteur, par exemple en accumulation ou en déplétion. Or, ce point est important pour la caractérisation du semiconducteur dans la mesure où les défauts peuvent être répartis sur toute la bande interdite du semiconducteur. Par conséquent, la technique pp-KPFM ne permet généralement pas d'évaluer la dynamique de SPV par rapport à la position énergétique des défauts.

La technique pp-KPFM reste une technique relativement lente. Par exemple, une mesure de dynamique de SPV comprenant un dizaine de mesures (c'est à dire une dizaine de déphasages entre la pompe et la sonde) nécessite environ une dizaine de minutes d'acquisition, et ce, pour un seul point de mesure qui correspond sensiblement à la taille de l'extrémité libre de la pointe, qui peut être de quelques nanomètres à quelques dizaines de nanomètres. Si l'on souhaite caractériser une surface importante de semiconducteur, par exemple une plaquette (wafer) entière de 200 mm ou de 300 mm, cela demande de réaliser un nombre important de mesures de dynamique de SPV, en déplaçant à chaque fois la pointe pour couvrir une telle surface, augmentant d'autant le temps de mesure. Dit autrement, avec un temps de mesure total raisonnable industriellement (typiquement inférieur à une heure), la technique pp-KPFM ne permet de couvrir qu'une partie très limitée d'un wafer.

En outre, la technique pp-KPFM est dépendante de la qualité de la pointe. Par exemple, une pointe cassée ou contaminée peut conduire à une interprétation erronée de la dynamique de SPV mesurée avec cette pointe, et par exemple à une caractérisation erronée de défauts dans le semiconducteur. Par conséquent, la pointe doit souvent être changée afin de préserver la qualité des mesures, ce qui induit des manipulations qui augmentent le temps de mesure total.

Les inventeurs proposent un système de caractérisation permettant de répondre aux besoins d'amélioration des systèmes décrits précédemment, et de pallier tout ou partie des inconvénients de ces systèmes.

Des modes de réalisation de systèmes de caractérisation vont être décrits ci-après. Les modes de réalisation décrits sont non limitatifs et diverses variantes apparaîtront à la personne du métier à partir des indications de la présente description.

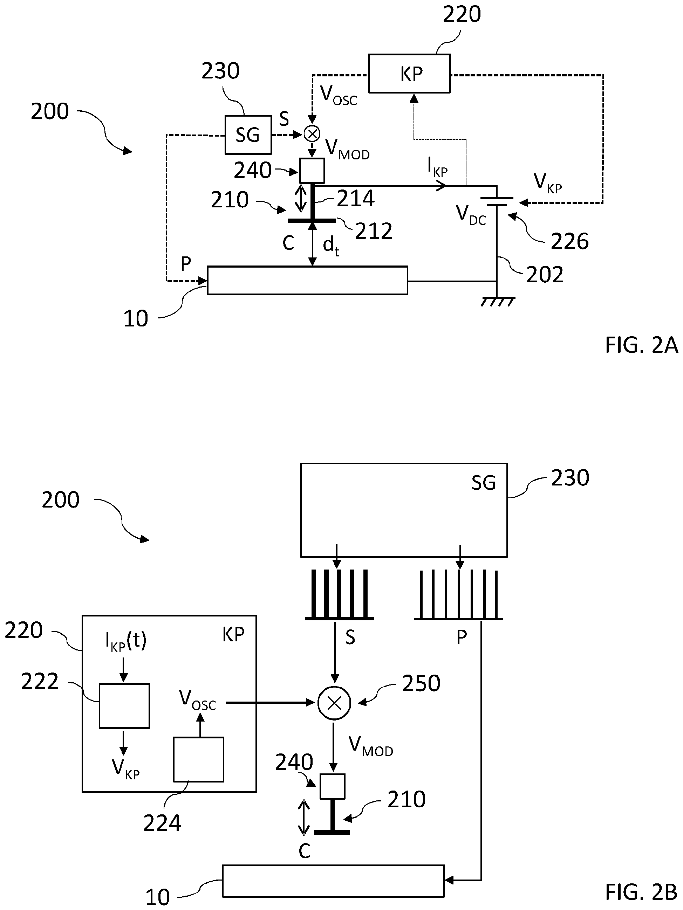

La figure 2A représente schématiquement un système de caractérisation 200 selon un mode de réalisation. La figure 2B représente schématiquement sous forme de blocs le système de la figure 2A.

Le système de caractérisation 200 comprend une sonde macroscopique de Kelvin 210.

Le terme "macroscopique" désigne une sonde dont l'extrémité qui est destinée à être positionnée au droit de l'échantillon de semiconducteur n'est pas une pointe de quelques nanomètres ou dizaines de nanomètres mais forme une plaque conductrice électriquement qui est destinée à faire face à l'échantillon de semiconducteur. La plaque peut former un plan dont les dimensions sont comprises entre une dizaine de micromètres, par exemple 15 micromètres, à quelques centaines de micromètres, voire à quelques millimètres.

La sonde macroscopique 210 représentée comprend une tige 214 au bout de laquelle est attachée une plaque métallique 212 (première extrémité de la sonde) positionnée à une distance $d_t$ d'un échantillon de semiconducteur 10 et formant une capacité parallèle avec la surface supérieure (première surface) dudit échantillon. Une deuxième extrémité de la sonde macroscopique est reliée électriquement à l'échantillon par un circuit électrique 202. D'autres structures de sonde macroscopique sont possibles dans la mesure où elles permettent de former une plaque conductrice destinée à faire face à l'échantillon de semiconducteur.

Une sonde macroscopique de Kelvin repose sur un principe de fonctionnement différent du KPFM, comme décrit dans l'exemple qui suit.

Par exemple, si $V_{surf}$ et $V_{sonde}$ sont les valeurs de potentiel électrostatique respectivement à la surface de l'échantillon et de la plaque de la sonde, la charge $Q_{sonde}$ portée par la plaque de la sonde peut s'écrire:

$$Q_{sonde} = C\big(V_{sonde} - V_{surf}\big) = \frac{\varepsilon A}{d_t}\big(V_{sonde} - V_{surf}\big)$$

où C est la capacité du système sonde-échantillon et $d_t$, $\varepsilon$, A sont respectivement la distance, la permittivité du milieu et la surface effective d'interaction entre la sonde et l'échantillon.

La différence de potentiel de contact CPD est alors définie comme la différence de potentiel électrostatique entre la surface supérieure de l'échantillon et la plaque de la sonde à l'équilibre, soit :

$$CPD = \big(V_{surf} - V_{sonde}\big)_{\text{équilibre}}$$

Le système 200 représenté comprend un générateur de tension 226 adapté à appliquer une tension de polarisation continue $V_{DC}$ entre la plaque et l'échantillon de sorte que la différence de potentiel électrostatique entre les deux surfaces est modifiée. Cela peut se représenter ainsi :

$$\big(V_{sonde} - V_{surf}\big) = \big(V_{sonde} - V_{surf}\big)_{\text{équilibre}} + V_{DC} = V_{DC} - CPD$$

Le générateur de tension 226 peut être positionné au niveau du circuit électrique 202 entre la deuxième extrémité de la sonde macroscopique 210 et l'échantillon 10.

Il est alors possible d'annuler la différence de potentiel entre les deux surfaces lorsque :

$$V_{DC} = CPD$$

Le système 200 comprend un générateur de vibration 240 adapté à appliquer à la plaque 212 un mouvement d'oscillation selon une direction perpendiculaire à la surface supérieure de l'échantillon 10. Le générateur de vibration peut par exemple être un actionneur piézo-électrique ou une bobine acoustique.

Par exemple, l'oscillation peut modifier périodiquement la distance $d_t$ entre la plaque et la surface supérieure de l'échantillon de telle sorte que :

$$d_t(t) = d_0 + \Delta d \cos \omega t$$

où $d_t$ est la distance entre la surface supérieure de l'échantillon et la sonde pendant l'oscillation, $d_0$ la distance moyenne entre la sonde et la surface supérieure de l'échantillon, $\Delta d$ l'amplitude d'oscillation et $\omega$ la pulsation d'oscillation de la sonde.

Cette oscillation modifie également les caractéristiques de la capacité C entre la plaque et l'échantillon, ce qui génère une variation de la charge des deux surfaces en regard et donc l'apparition d'un courant $I_{KP}$ dans le circuit électrique 202 reliant la sonde et l'échantillon de semiconducteur, si les deux surfaces ne sont pas au même potentiel électrostatique. Ce courant $I_{KP}$ est périodique et peut posséder la même forme d'onde et la même fréquence que l'oscillation de la sonde, comme montré, par exemple, dans la formule suivante qui découle de la formule précédente donnant la charge $Q_{sonde}$ portée par la plaque de la sonde :

$$I_{KP}(t) = \frac{\partial Q_{sonde}}{\partial t} = \frac{\varepsilon A (V_{DC} - CPD)}{d_t^2} \omega \Delta d \sin(\omega t)$$

Lorsque la polarisation continue $V_{DC}$ compense la différence de potentiel de contact, i.e. lorsque $V_{DC} = CPD$, alors le courant périodique $I_{KP}(t)$ disparaît. La valeur de différence de potentiel de contact CPD peut ainsi être obtenue en ajustant la tension de polarisation $V_{DC}$ de manière à ce que le courant périodique $I_{KP}(t)$ disparaisse, ou du moins ne soit plus détectable par un appareil de mesure de courant.

Cette valeur de tension de polarisation, qui peut être désignée "tension de compensation", peut être déterminée par une boucle de rétroaction, avec en entrée une mesure du courant $I_{KP}$. La boucle de rétroaction peut être tout type de boucle de rétroaction couramment utilisée dans une sonde macroscopique de Kelvin, de manière connue pour une personne du métier. La valeur de tension de polarisation générée par la boucle de rétroaction peut être désignée $V_{KP}$.

Le mouvement d'oscillation de la plaque peut être commandé par une tension sinusoïdale $V_{OSC}$ de vibration. Dans la suite de la description et dans les figures 2A et 2B, on considère ce cas. Alternativement, le mouvement d'oscillation pourrait être commandé par une autre grandeur qu'une tension, par exemple un courant ; dans ce cas, c'est cette autre grandeur qui peut être combinée avec le premier signal de tension S, au lieu d'une tension comme décrit ci-après.

La mesure de photo-tension de surface SPV avec la sonde macroscopique de Kelvin est réalisée en déterminant et en comparant des valeurs de CPD obtenues à l'obscurité et sous illumination, toutes autres conditions similaires.

Pour déterminer la photo-tension de surface de manière résolue dans le temps, la mesure par sonde macroscopique de Kelvin est combinée avec la technique pompe-sonde. Comme expliqué plus avant, la technique pompe-sonde consiste à exciter un semiconducteur (pompe), puis à mesurer une réponse du semiconducteur à cette excitation suivant une fenêtre temporelle (sonde) qui se déplace dans le temps. La résolution temporelle de la mesure peut être réglée en réglant différents décalages temporels (déphasages) entre l'excitation et la mesure, c'est-à-dire entre la pompe et la sonde. On peut également agir sur la largeur du signal sonde. La largeur du signal pompe peut déterminer la dynamique minimum mesurable.

Ainsi, le système 200 représenté comprend deux blocs principaux :

- un bloc sonde de Kelvin (bloc KP) 220 comprenant : une boucle de rétroaction 222, avec en entrée une mesure du courant $I_{KP}(t)$ et en sortie une valeur $V_{KP}$ de tension de polarisation, ladite valeur permettant de déterminer une différence de potentiel de contact CPD ; et une unité de commande 224 du générateur de vibration 240 adaptée à générer une tension de commande $V_{OSC}$ sinusoïdale (tension de commande de vibration) ;
- un bloc de génération de signal (bloc SG) 230 adapté à générer des signaux de tension : un premier signal de tension S pour la sonde, et un deuxième signal de tension P pour la pompe.

Les signaux générés par le bloc SG 230 sont représentés sous forme d'impulsions, ou pulses, par exemple sous forme de créneaux, mais d'autres formes de signaux sont envisageables, notamment pour le signal de la pompe, selon le moyen d'excitation du semiconducteur envisagé.

On peut utiliser un seul générateur pour former les signaux de la pompe et de la sonde, ou bien deux générateurs différents.

Le système 200 représenté comprend en outre un multiplicateur de tension 250 adapté à multiplier la tension de commande $V_{OSC}$ sinusoïdale du bloc KP 220 par le premier signal de tension S du bloc SG 230.

La multiplication de la tension de commande $V_{OSC}$ sinusoïdale par le premier signal de tension S donne une tension de commande modulée $V_{MOD}$ (tension de commande modulée de vibration) qui correspond à une tension constituée d'impulsions avec la même enveloppe sinusoïdale que la tension de commande $V_{OSC}$ et qui est envoyée au générateur de vibration 240 pour générer une oscillation de la plaque 212. De cette manière, la boucle de rétroaction 222 ne compense que la différence de potentiel de contact (CPD) entre la plaque et l'échantillon qui existe pendant chaque impulsion.

Le deuxième signal de tension P du bloc 230 permet l'excitation de l'échantillon 10, par exemple une illumination. Le signal de tension P de la pompe et le signal de tension S de la sonde (et ainsi la tension de commande modulée $V_{MOD}$) sont synchronisés via un synchroniseur ou directement au sein du générateur de signal dans le bloc SG 230. L'évolution temporelle de la CPD est surveillée en enregistrant la tension ($V_{KP}$) à la sortie de la boucle de rétroaction 222 en fonction du déphasage entre les impulsions de la sonde et celles de la pompe. Le déphasage est par exemple un retard du signal de la sonde par rapport au signal de la pompe.

Le déphasage du signal de la sonde par rapport au signal de la pompe peut être réglé par exemple au sein du générateur de signal dans le bloc SG 230, ou via un élément électronique dédié en sortie du générateur de signal.

Ainsi, la technique pompe-sonde combinée avec une sonde macroscopique de Kelvin (pp-KV) permet de mesurer une différence de potentiel de surface en fonction du déphasage entre la pompe et la sonde, et ce, selon différents déphasages de la sonde par rapport à la pompe. Cela permet donc de générer des mesures de photo-tension de surface (SPV) résolues dans le temps, c'est à dire une dynamique de SPV.

Une dynamique de SPV peut par exemple être représentée sous forme de spectre ou de courbe. Le spectre ou la courbe SPV, plus généralement la dynamique de SPV, peut ensuite être interprétée pour déterminer et/ou caractériser la présence ou non de défaut(s) dans le semiconducteur. Par exemple, il est possible de différencier les mécanismes de recombinaison de charge des mécanismes de piégeage de charge, ces deux mécanismes pouvant être impliqués par plusieurs types de défauts.

Par rapport à la technique pp-KPFM décrite plus avant, la technique pompe-sonde combinée avec la sonde macroscopique de Kelvin (pp-KP) selon un mode de réalisation permet, en changeant le mode de mesure du CPD, d'utiliser une plaque plutôt qu'une pointe nanométrique, et donc d'augmenter la surface d'acquisition, de façon à pouvoir caractériser une surface importante de semiconducteur, par exemple une plaquette (wafer) de 200 mm ou de 300 mm, sans augmenter de manière déraisonnable le temps de mesure. Les inventeurs ont estimé que le temps de mesure avec la technique pp-KP pour un wafer de ces tailles pouvait être d'une à quelques heures selon les configurations de mesure, à comparer avec une durée qui peut être d'un ou plusieurs jours avec la technique pp-KPFM.

L'aire de la plaque peut être choisie par exemple en fonction de la résolution spatiale de mesure souhaitée, ou d'un compromis entre résolution spatiale et temps de mesure.

En outre, le système de caractérisation selon un mode de réalisation, en n'utilisant plus de pointe, n'est plus sensible à la dégradation de la pointe, aux risques d'erreur qu'une telle dégradation implique et aux pertes de temps de mesure dues à la nécessité de changer la pointe.

De plus, l'augmentation de la surface d'acquisition de la sonde permet d'améliorer la sensibilité énergétique de la mesure grâce à une plus grande capacité entre la sonde et le semiconducteur. Les inventeurs ont estimé que la technique pp-KP selon un mode de réalisation pouvait permettre d'augmenter la sensibilité en énergie et donc indirectement la résolution temporelle de la mesure (la résolution temporelle de l'approche pompe-sonde étant généralement limitée par le rapport signal sur bruit). En effet, l'augmentation de la surface de la sonde permet d'améliorer la sensibilité énergétique de la mesure grâce à une plus grande surface sondée. Par exemple, il est possible d'effectuer des mesures de SPV par une sonde macroscopique de Kelvin (KP) non résolue en temps sur des couches d'oxyde de 100 nm avec un rapport signal sur bruit inférieur à 3 mV, ce qui n'est pas réalisable avec une technique KPFM, et a fortiori pas avec une technique pp-KPFM. Par conséquent, les inventeurs ont estimé que la technique pp-KP selon un mode de réalisation pouvait permettre d'effectuer des mesures de SPV résolues en temps sur des couches d'oxyde plus épaisses que 50 nm, par exemple 100 nm ou plus. Ce dernier point est particulièrement intéressant pour l'étude des procédés de passivation puisque l'empilement complet peut être supérieur à 100 nm.

Ainsi, les inventeurs ont estimé qu'un système de caractérisation selon un mode de réalisation pouvait améliorer la résolution temporelle de l'approche pompe-sonde, même avec des couches d'oxyde épaisses, typiquement d'une épaisseur de 100 nm ou plus. Un avantage est une meilleure caractérisation des défauts du semiconducteur.

Un autre avantage est que la technique pp-KP se fait sans contact entre la sonde macroscopique et le semiconducteur, ce qui la rend non destructive. En effet, en comparaison à d'autres techniques de caractérisation de défauts, la technique pp-KP ne nécessite pas de préparation de surface particulière. Par exemple, ceci est intéressant pour le suivi de la dérive d'un procédé en production.

De plus, l'utilisation d'une sonde macroscopique peut être combinée avec un dépôt quantifié d'ions (charge), négatifs ou positifs, en surface de l'échantillon de semiconducteur. Ceci permet de modifier le régime électrique en surface du semiconducteur, par exemple en accumulation ou en déplétion, et par conséquent d'évaluer la dynamique du SPV en fonction du niveau d'énergie des défauts.

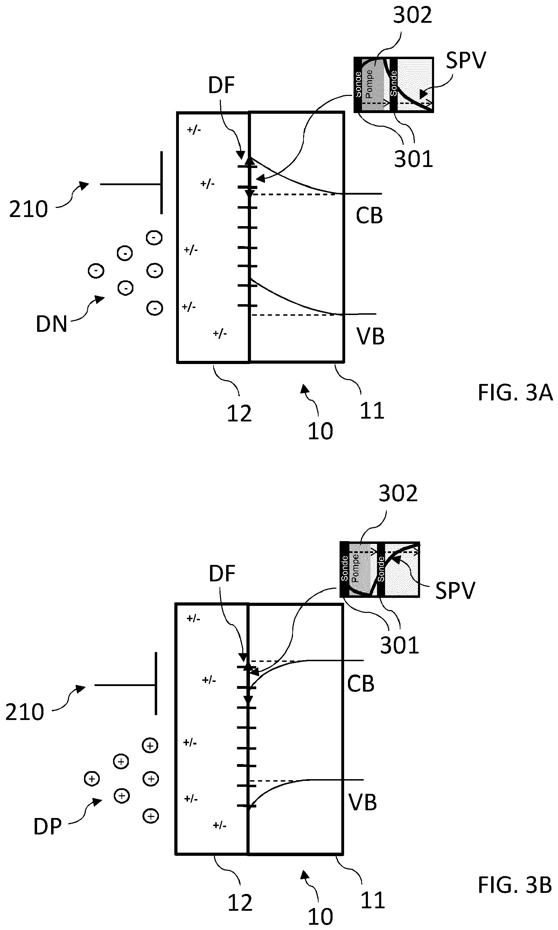

Les figures 3A et 3B illustrent des modes de réalisation de procédé de caractérisation de semiconducteur dans lesquels un dépôt d'ions négatifs DN (figure 3A) ou positifs DP (figure 3B) est réalisé en surface de l'échantillon 10 de semiconducteur. L'échantillon 10 comprend une couche d'oxyde 12 sur une couche de semiconducteur 11 et le dépôt d'ions est réalisé sur la couche d'oxyde 12.

Dit autrement, La figure 3A illustre la surface du semiconducteur en accumulation induit par le dépôt de charges négatives sur l'oxyde, et la figure 3B illustre la surface du semiconducteur en déplétion/inversion induit par le dépôt de charges positives sur l'oxyde.

Les figures 3A et 3B montrent les courbes de bandes de valence VB et de conduction CB dans la couche de semiconducteur 11. Des courbures de bande apparaissent à la surface du semiconducteur en raison de la présence d'états de surface et peuvent être modifiées en raison de la présence de défauts DF. Les courbures de bandes dépendent également de la configuration de mesure : sous illumination ou à l'obscurité ; et/ou avec un dépôt d'ions négatifs DN ou d'ions positifs DP en surface de l'échantillon (sur la couche d'oxyde 12) .

Le positionnement de la sonde macroscopique 210 d'un système de caractérisation 200 selon un mode de réalisation en face de l'échantillon 10 de semiconducteur, associé avec le système pompe-sonde permet de générer une courbe de mesures de photo-tension de surface (SPV) résolues dans le temps. Les différents points de la courbe sont générés en "déplaçant" la sonde 301 par rapport à la pompe 302, c'est-à-dire en jouant sur le déphasage du signal de la sonde par rapport au signal de la pompe.

On peut observer que les bandes de valence et de conduction avec dépôt d'ions positifs ont des tangentes inversées par rapport aux bandes de valence et de conduction avec dépôt d'ions négatifs, et cette inversion de tangente se répercute sur les courbes de dynamique de SPV.

Ces mesures peuvent permettre de caractériser les défauts (via les dynamiques du SPV) en fonction de leurs positions en énergie dans la bande interdite du semiconducteur. Pour simplifier, sur les figures 3A et 3B, le passage d'accumulation vers inversion est illustré par un changement de signe du SPV. En réalité, cela peut se traduire par des dynamiques du SPV différentes. Par exemple, en fonction du régime, cela peut permettre d'accéder à des défauts qui n'étaient pas accessibles sans le dépôt de charge par la technique pp-KPFM.

Pour l'ensemble des modes de réalisation, la pompe correspond à un signal d'excitation de l'échantillon de semiconducteur, par exemple une illumination par Laser ou autre rayonnement lumineux, ou une excitation électrique ou magnétique.

Les modes de réalisations peuvent être mis en œuvre pour la caractérisation des défauts de semiconducteur, par exemple dans une cellule solaire, un photodétecteur, un transistor, une diode électroluminescente (LED).

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la sonde macroscopique peut présenter d'autres formes dans la mesure où celles-ci permettent de former une plaque conductrice destinée à faire face à l'échantillon de semiconducteur.

Enfin, la mise en oeuvre pratique des modes de réalisation et variantes décrits est à la portée de la personne du métier à partir des indications fonctionnelles données ci-dessus.

**Revendications**

1.   Système (200) de caractérisation d'un semiconducteur par mesure de photo-tension de surface, le système comprenant :

- une sonde de Kelvin (210) comprenant à une première extrémité une plaque (212) électriquement conductrice adaptée à être disposée en regard d'une première surface d'un échantillon (10) de semiconducteur ;
- un circuit électrique (202) relié à une autre extrémité de la sonde et adapté à relier électriquement ladite sonde à l'échantillon ;
- un générateur (230) de signal d'excitation (P) adapté à exciter le semiconducteur ;
- un générateur de vibration (240) adapté à appliquer à la plaque un mouvement d'oscillation selon une direction sensiblement orthogonale à la première surface de l'échantillon ;
- une unité de commande (224) du générateur de vibration adaptée à générer un signal de commande ($V_{OSC}$) de vibration ;
- un générateur (230) de signal de modulation (S) adapté à moduler le signal de commande ($V_{OSC}$) de manière à former un signal de commande modulé ($V_{MOD}$) destiné à être envoyé au générateur de vibration (240) ; le signal de modulation étant déphasé, d'une valeur de déphasage, par rapport au signal d'excitation ; et
- un moyen de détermination d'une valeur ($V_{KP}$) de tension de polarisation ($V_{DC}$) entre la sonde de Kelvin et l'échantillon, ladite valeur étant déterminée sur la base d'un courant ($I_{KP}$) généré dans le circuit électrique (202) par l'oscillation de la plaque (212), et ladite valeur permettant de déterminer une valeur de photo-tension de surface (SPV) du semiconducteur, pour la valeur de déphasage ; et
- un moyen de réglage du déphasage du signal de modulation (S) par rapport au signal d'excitation (P), configuré pour appliquer plusieurs valeurs de déphasage entre ledit signal de modulation et ledit signal d'excitation ;

le moyen de détermination étant adapté à déterminer, pour chaque valeur de déphasage, une valeur ($V_{KP}$) de tension de polarisation ($V_{DC}$) sur la base du courant ($I_{KP}$) généré dans le circuit électrique (202) par l'oscillation de la plaque (212), chaque valeur de tension de polarisation déterminée permettant de déterminer une valeur de photo-tension de surface (SPV) du semiconducteur.

2.   Système (200) selon la revendication 1, comprenant un générateur de tension (226) adapté à générer la tension de polarisation ($V_{DC}$) entre la sonde de Kelvin et l'échantillon.

3.   Système (200) selon la revendication 1 ou 2, dans lequel le moyen de détermination comprend une boucle de rétroaction (222) avec en entrée le courant ($I_{KP}$), et en sortie la valeur ($V_{KP}$) de tension de polarisation qui permet de réduire le courant ($I_{KP}$), par exemple d'annuler ledit courant.

4.   Système (200) selon l'une quelconque des revendications 1 à 3, comprenant un multiplicateur de tension (250) configuré pour multiplier le signal de commande ($V_{OSC}$) de vibration par le signal de modulation (S).

5.   Système selon l'une quelconque des revendications 1 à 4, dans lequel le moyen de réglage du déphasage du signal de modulation (S) par rapport au signal d'excitation (P) comprend un retardateur.

6.   Système (200) selon l'une quelconque des revendications 1 à 5, dans lequel la plaque (212) s'étend selon un plan principal destiné à être disposé en regard de la première surface de l'échantillon (10), les dimensions de la plaque dans ledit plan principal étant supérieures ou égales à 15 micromètres.

**7.** Procédé de caractérisation d'un semiconducteur par mesure de photo-tension de surface, le procédé mettant en œuvre un système de caractérisation selon l'une quelconque des revendications 1 à 6, et comprenant :

- disposer la plaque (212) électriquement conductrice en regard d'une première surface d'un échantillon (10) de semiconducteur, et relier l'autre extrémité de la sonde à l'échantillon par le circuit électrique (202) ;
- générer un signal d'excitation (P) à l'aide du générateur (230) de signal d'excitation, de manière à exciter le matériau semiconducteur ;
- générer un signal de commande ($V_{OSC}$) de vibration à l'aide de l'unité de commande (224) ;
- générer un signal de modulation (S) à l'aide du générateur (230) de signal de modulation, et moduler le signal de commande ($V_{OSC}$) de vibration par le signal de modulation (S) de manière à générer un signal de commande modulé ($V_{MOD}$) ; le signal de modulation étant déphasé d'une valeur de déphasage par rapport au signal d'excitation ;
- générer, à l'aide du générateur de vibration (240) commandé par le signal de commande modulé ($V_{MOD}$), un mouvement d'oscillation de la plaque (212) selon une direction sensiblement orthogonale à la première surface de l'échantillon ;
- déterminer une valeur ($V_{KP}$) de tension de polarisation ($V_{DC}$) entre la sonde de Kelvin et l'échantillon sur la base d'un courant ($I_{KP}$) généré dans le circuit électrique (202) par l'oscillation de la plaque (212) ; et
- déterminer une valeur de photo-tension de surface (SPV) sur la base de la valeur ($V_{KP}$) déterminée de tension de polarisation, pour la valeur de déphasage ;

le procédé comprenant en outre :

- régler plusieurs valeurs de déphasage du signal de modulation (S) par rapport au signal d'excitation (P) ;
- déterminer, pour chaque valeur de déphasage, une valeur ($V_{KP}$) de tension de polarisation sur la base du courant ($I_{KP}$) généré dans le circuit électrique (202) par l'oscillation de la plaque (212) ; et
- déterminer une valeur de photo-tension de surface (SPV) sur la base de chaque valeur ($V_{KP}$) déterminée de tension de polarisation ;

le nombre de valeurs de déphasages étant par exemple adapté à déterminer une dynamique de photo-tension de surface dans le temps.

**8.** Procédé selon la revendication 7, comprenant en outre :

- générer la tension de polarisation ($V_{DC}$) entre la sonde de Kelvin et l'échantillon, pour la détermination de la valeur ($V_{KP}$) de tension de polarisation.

**9.** Procédé selon la revendication 7 ou 8, dans lequel la valeur ($V_{KP}$) de tension de polarisation est déterminée à l'aide d'une boucle de rétroaction (222) avec en entrée le courant ($I_{KP}$), ladite valeur de tension de polarisation étant sélectionnée pour réduire le courant ($I_{KP}$), par exemple annuler ledit courant.

**10.** Procédé selon l'une des revendications 7 à 9, comprenant en outre :

- déposer préalablement sur la première surface de l'échantillon (10) du semiconducteur des charges négatives ou positives ; la valeur de photo-tension de surface (SPV) étant déterminée en fonction du dépôt de charges réalisé.

**11.** Système (200) selon l'une quelconque des revendications 1 à 6, ou procédé selon l'une quelconque des revendications 7 à 10, dans lequel la tension de polarisation ($V_{DC}$) est une tension continue.

**12.** Système (200) selon l'une quelconque des revendications 1 à 6 et 11 ou procédé selon l'une quelconque des revendications 7 à 11, dans lequel le signal de commande ($V_{OSC}$) de vibration est une tension alternative.

**13.** Système (200) selon l'une quelconque des revendications 1 à 6, 11 et 12 ou procédé selon l'une quelconque des revendications 7 à 12, dans lequel le signal de modulation (S) comprend des impulsions, par exemple des impulsions de tension.

**14.** Système (200) selon l'une quelconque des revendications 1 à 6, 11 à 13 ou procédé selon l'une quelconque des revendications 7 à 13, dans lequel le signal d'excitation (P) est un signal Laser, un signal électrique ou un signal magnétique, par exemple sous forme d'impulsions.

EP 4 187 265 A1

FIG. 1A

FIG. 1B

12

FIG. 2A

FIG. 2B

302

SPV

DF

301

210

+/-

+/-

+/-

+/-

+/-

⊙ ⊙
⊙ ⊙ ⊙
⊙ ⊙
⊙

CB

DN

VB

12

10

11

FIG. 3A

302

DF

301

SPV

210

+/-

+/-

+/-

+/-

+/-

⊕ ⊕
⊕ ⊕ ⊕
⊕ ⊕
⊕

CB

DP

VB

12

10

11

FIG. 3B

Europäisches
Patentamt

European
Patent Office

Office européen
des brevets

# RAPPORT DE RECHERCHE EUROPEENNE

Numéro de la demande

**EP 22 20 8996**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | ELKE BEYREUTHER ET AL: "Designing a Robust Kelvin Probe Setup Optimized for Long-Term Surface Photovoltage Acquisition", SENSORS, vol. 18, no. 11, 21 novembre 2018 (2018-11-21), page 4068, XP055738688, DOI: 10.3390/s18114068 | 1-3,6-9, 14 | INV. G01R31/28 G01R31/26 G01R31/265 G01Q60/24 G01Q60/30 |
| Y | * le document en entier * | 4,5,11, 13 | |
| | ----- | | |
| Y | LIAM COLLINS ET AL: "Towards nanoscale electrical measurements in liquid by advanced KPFM techniques: a review", REPORTS ON PROGRESS IN PHYSICS, INSTITUTE OF PHYSICS PUBLISHING, BRISTOL, GB, vol. 81, no. 8, 10 juillet 2018 (2018-07-10), page 86101, XP020329010, ISSN: 0034-4885, DOI: 10.1088/1361-6633/AAB560 [extrait le 2018-07-10] | 11,13 | |
| A | * alinéa [4.3.3]; figure 36 * | 1,7 | DOMAINES TECHNIQUES RECHERCHES (IPC) G01R G01Q |
| | ----- | | |
| Y | MURAWSKI J ET AL: "Pump-probe Kelvin-probe force microscopy: Principle of operation and resolution limits", JOURNAL OF APPLIED PHYSICS, AMERICAN INSTITUTE OF PHYSICS, 2 HUNTINGTON QUADRANGLE, MELVILLE, NY 11747, vol. 118, no. 15, 21 octobre 2015 (2015-10-21), XP012201357, ISSN: 0021-8979, DOI: 10.1063/1.4933289 [extrait le 1901-01-01] | 4,5 | |
| A | * le document en entier * | 1,7 | |
| | ----- | | |
| | -/-- | | |

Le présent rapport a été établi pour toutes les revendications

| Lieu de la recherche | Date d'achèvement de la recherche | Examinateur |
|---|---|---|
| Munich | 6 avril 2023 | Hijazi, Ali |

EPO FORM 1503 03.82 (P04C02)

Europäisches
Patentamt

European
Patent Office

Office européen
des brevets

**RAPPORT DE RECHERCHE EUROPEENNE**

Numéro de la demande

**EP 22 20 8996**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2014/084902 A1 (BAIKIE IAIN [GB]) 27 mars 2014 (2014-03-27) * alinéa [0071] – alinéa [0261]; figures 1-32 * | 1,6,7, 10,12 | |
| X | US 4 393 348 A (GOLDSTEIN BERNARD ET AL) 12 juillet 1983 (1983-07-12) * colonne 2, ligne 44 – colonne 8, ligne 55; figures 1-5 * | 1,6,7 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 6 avril 2023 | Hijazi, Ali |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...............................................................
& : membre de la même famille, document correspondant

EPO FORM 1503 03.82 (P04C02)

**EP 4 187 265 A1**

## ANNEXE AU RAPPORT DE RECHERCHE EUROPEENNE
## RELATIF A LA DEMANDE DE BREVET EUROPEEN NO.

EP 22 20 8996

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-04-2023

| Document brevet cité au rapport de recherche | Date de publication | Membre(s) de la famille de brevet(s) | Date de publication |
|---|---|---|---|
| US 2014084902 A1 | 27-03-2014 | EP 2783205 A1 | 01-10-2014 |
| | | GB 2495998 A | 01-05-2013 |
| | | JP 6018645 B2 | 02-11-2016 |
| | | JP 2015510595 A | 09-04-2015 |
| | | US 2014084902 A1 | 27-03-2014 |
| | | WO 2013124663 A1 | 29-08-2013 |
| US 4393348 A | 12-07-1983 | AUCUN | |

EPO FORM P0460

Pour tout renseignement concernant cette annexe : voir Journal Officiel de l'Office européen des brevets, No.12/82